# EUROPÄISCHE PATENTANMELDUNG

(11) **EP 0 599 071 A1**
(43) Veröffentlichungstag der Anmeldung: **01.06.1994**
(21) Anmeldenummer: 93117383.5
(22) Anmeldetag: 27.10.1993
(51) Int. Cl.: C03C 17/36, G02B 1/10, C23C 14/54, C23C 14/58

(54) **Transparentes Substrat mit einem transparenten Schichtsystem und Verfahren zur Herstellung eines solchen Schichtsystems**

(30) Priorität: 24.11.1992 DE 4239355
(71) Anmelder: LEYBOLD AKTIENGESELLSCHAFT, D-63450 Hanau (DE)
(72) Erfinder: Latz, Rudolf, Dr., D-63110 Rodgau (DE); Ocker, Berthold, D-59077 Hanau (DE); Schneider, Roland, Dipl.-Ing., D-63450 Hanau (DE)
(74) Vertreter: Schlagwein, Udo, Dipl.-Ing.

(57) **Zusammenfassung**

Auf einem Substrat (4) aus Glas ist eine Grundschicht (5) aus Indium-Zinn-Oxid (ITO-Schicht) und darauf eine dünne Metallschicht (6) aus vorzugsweise Silber gesputtert. Als Deckschicht (7) ist auf der Metallschicht (6) eine weitere Schicht aus Indium-Zinn-Oxid aufgesputtert. Diese Deckschicht (7) entspiegelt die Metallschicht (6), so daß die durch sie eintretende, starke Verminderung des elektrischen Widerstandes des Schichtpaketes nicht durch eine wesentliche Verminderung der Transmission erkauft werden muß.

## Beschreibung

Die Erfindung betrifft ein transparentes Substrat mit einem transparenten Schichtsystem, welches aus einer Metallschicht und einer die Metallschicht im sichtbaren Bereich entspiegelnden Deckschicht besteht, wobei die Metallschicht eine solche Schichtdicke hat, daß eine hohe Transparenz des Substrates erhalten bleibt. Weiterhin betrifft die Erfindung ein Verfahren zur Herstellung eines solchen Substrates mit einem transparenten Schichtsystem.

Für manche transparente Bauelemente ist es erforderlich, daß diese mit einer elektrisch leitfähigen Schicht oder einer Infrarotstrahlung oder Mikrowellen reflektierenden Schicht versehen werden, ohne daß dadurch die Transmission wesentlich herabgesetzt wird. Bei Displays werden zum Beispiel als dünne Beschichtung ausgebildete Elektroden auf eine Glasfläche aufgebracht. Ein solches Display, welches die eingangs genannten Merkmale aufweist, ist beispielsweise in den Patents Abstracts of Japan, P-1329, March 26, 1992, Vol.16, No. 121 beschrieben.

Glasscheiben von Backöfen oder Mikrowellenherden und Architekturglas sollen Strahlung möglichst weitgehend zurückhalten. Trotz einer hierfür geeigneten Beschichtung soll das Substrat mit der Beschichtung jedoch noch möglichst gut durchsichtig sein. Auch für diesen Anwendungsfall sind Schichtsysteme mit einer sehr dünnen Metallschicht und einer diese entspiegelnden Deckschicht bekannt, was die DE-A-40 06 804 zeigt.

Wenn man bei den bekannten Schichtsystemen einen geringen spezifischen Widerstand von unter 100 µOhm·cm erreichen will, was für Displays meist erforderlich ist, dann muß man eine relativ dicke ITO-Schicht vorsehen, was relativ teuer ist und wodurch die Transparenz des beschichteten Substrates unerwünscht stark verringert wird.

Der Erfindung liegt das Problem zugrunde, auf ein transparentes Substrat mit geringen Herstellungskosten ein Schichtsystem aufzubringen, welches eine hohe optische Transmission und einen geringen elektrischen Widerstand von unter 100 µOhm·cm hat. Weiterhin soll ein Verfahren zur Herstellung eines solchen Substrates geschaffen werden.

Das erstgenannte Problem wird erfindungsgemäß dadurch gelöst, daß die Metallschicht durch Beheizen des Substrates während der Beschichtung oder nach dem Erzeugen der Deckschicht einer Wärmebehandlung unterzogen wurde.

Durch eine solche Wärmebehandlung läßt sich bei einer Metallschicht mit einer Dicke von nur 8 bis 12 nm, ein elektrischer Widerstand von unter 100 µOhm·cm erreichen. Je nach den Eigenschaften der Metallschicht erfolgt diese Wärmebehandlung durch Aufheizen des Substrates bei der Beschichtung oder nachträglich nach dem Aufbringen der Deckschicht. Letzteres ist notwendig, wenn die Metallschicht zum Reißen bei Temperatureinwirkung neigt, was insbesondere bei einer Metallschicht aus Silber der Fall ist. Silber bricht bei Temperaturen über 150°C auf, und es kommt dann zu Rissen und Klümpchenbildungen. Sobald jedoch die Deckschicht aufgebracht ist, kann sich die Metallschicht durch Temperatureinwirkung nicht mehr in einem für die optischen Eigenschaften nachteiligen Sinne verändern, vielmehr lassen sich dadurch ihre Absorption und die Reflexion vermindern.

Praktisch erprobt wurde ein Substrat, bei dem unterhalb der Metallschicht eine Grundschicht auf das Substrat aufgetragen ist und diese Grundschicht und die Deckschicht aus Indium-Zinn-Oxid (ITO-Schicht) bestehen. Dabei wirkt die Grundschicht als Diffusionsbarriere, teilweise zusammen mit der Deckschicht als Entspiegelungsschicht und als Haftvermittler für die Metallschicht. Mit einem solchen Schichtsystem läßt sich eine besonders hohe Transmission bei einem spezifischen Widerstand der Schicht von unter 100 µOhm·cm erreichen. Die Erfindung kann jedoch auch mit anderen Materialien für die Grund- und Deckschicht verwirklicht werden, z.B. SiO₂ oder SnO₂.

Für die Anwendung als Display lassen sich mit geringem Kostenaufwand ausreichend gute optische und elektrische Werte erzielen, wenn die Metallschicht aus Silber besteht und die Wärmebehandlung nach dem Erzeugen der Deckschicht erfolgte. Durch diese nachträgliche Wärmebehandlung kann man die Silberschicht ohne Gefahr eines Aufreißens auf bis zu 300°C aufheizen.

Das Aufheizen kann schon während der Erzeugung der Schichten erfolgen, wenn gemäß einer anderen Weiterbildung der Erfindung die Metallschicht aus Gold, Kupfer oder einer bei einer Wärmebehandlung nicht zum Reißen neigenden Legierung aus Silber, Gold oder Kupfer besteht und die Wärmebehandlung beim Erzeugen der Metallschicht und der ITO-Schichten durch Beheizen des Substrates erfolgte. Metallegierungen als Metallschicht haben gegenüber reinem Silber oder Gold den Vorteil, durch Erhöhung der Härte der Metallschicht zu einer hohen Abriebfestigkeit und Kratzfestigkeit des Schichtsystems zu führen.

Die Metallschicht wird ohne wesentliche Verminderung der Transmission ganz besonders hart, so daß das Schichtpaket insgesamt mechanisch besonders widerstandsfähig ist, wenn gemäß einer anderen Weiterbildung der Erfindung die Metallschicht eine Legierung aus Silber, Gold oder Kupfer und einem geringen Anteil eines Legierungsstoffes, wie Zirkonium, Vanadium, Nickel, Chrom, Molybdän, Platin, Paladium, Rhodium, Iridium, Silizium oder Wolfram ist.

Vorteilhaft ist es auch, wenn die Metallschicht die im Anspruch 6 gekennzeichnete Zusammensetzung hat.

Eine besonders harte Silber-Kupferlegierung ergibt sich durch die im Anspruch 7 angegebenen Legierungsanteile.

Die Silberlegierung hat besonders feines Korn bei guter Härte, wenn sie die im Anspruch 8 angegebene Zusammensetzung aufweist.

Auch eine Hartsilberlegierung ist möglich, wenn sie die im Anspruch 9 angegebene Zusammensetzung hat.

Eine besonders harte Legierung aus Silber, Gold und Kupfer ergibt sich durch die im Anspruch 10 festgelegten Legierungsanteile.

Für Legierungen mit hohem Goldanteil sind desweiteren die in den Ansprüchen 11 bis 15 angegebenen Legierungsanteile vorteilhaft.

Auch eine Weißgoldlegierung kommt in Frage, wenn sie gemäß Anspruch 16 mindestens 50 Gew.-% Gold und als zusätzlichen Legierungsbestandteil Nickel, Palladium oder Silber aufweist.

Vorzugsweise soll die Grundschicht 40 bis 200 nm, die Deckschicht 40 bis 60 nm und die Metallschicht 8 bis 15 nm dick sein. Eine ganz besonders geringe Verschlechterung der Transmission von Glas infolge des Schichtpaketes bei geringem elektrischen Widerstand der Schicht läßt sich erreichen, wenn die Grundschicht eine 48,8 nm dicke ITO Schicht, die Metallschicht eine 10 nm dicke Silberschicht und die Deckschicht eine 44 nm dicke ITO-Schicht ist. Abgesehen von der Verwendung eines solchen beschichteten Substrats als Display könnte man es bei Backöfen und Mikrowellenherden als Frontscheibe oder bei Gebäuden als Architekturglas einsetzen, weil die Schicht Infrarotwellen und Mikrowellen sehr gut reflektiert, so daß eine solche Frontscheibe sich nicht unerwünscht erwärmen und die Wärme nicht durchlassen würde.

Das zweitgenannte Problem, nämlich die Schaffung eines Verfahrens zur Herstellung eines transparenten leitfähigen Schichtsystems auf einem transparenten Substrat wird erfindungsgemäß dadurch gelöst, daß die Metallschicht durch Beheizen des Substrates während der Beschichtung oder nach dem Erzeugen der Deckschicht einer Wärmebehandlung bei Temperaturen bis zu 300°C unterzogen wird.

Mit einem solchen Verfahren lassen sich mit verhältnismäßig geringem Kostenaufwand elektrisch gut leitfähige Schichten auf einem Substrat aufbringen, welche die Transmission nur unwesentlich verringern.

Wählt man als Metallschicht eine Silberschicht, dann ist es vorteilhaft, wenn die Wärmebehandlung dadurch erfolgt, daß das Substrat nach der Beschichtung in einer Vakuumanlage oder einem Temperofen bei Temperaturen von bis zu 300°C bis zu einer Stunde getempert wird. Überraschenderweise hat sich gezeigt, daß infolge der Schutzwirkung der Deckschicht keine nachteiligen Veränderungen der Metallschicht, wie Rißbildung oder Klümpchenbildung, auftritt.

Besonders günstig ist die Deckschicht aufzubringen, wenn sie durch teilreaktives Sputtern von einem ITO-Target hergestellt wird, wobei der Partialdruck des Sauerstoffs nicht über etwa 10⁻⁴ mb liegt. Unter solchen Bedingungen verändert sich beim Aufbringen der Deckschicht die Metallschicht nicht.

Verunreinigungen des Substrats beeinflussen die Metallschicht nicht, wenn unmittelbar auf das Substrat vor dem Aufsputtern der Metallschicht eine Grundschicht aus Indium-Zinn-Oxid aufgesputtert wird. Eine solche Grundschicht wirkt als Diffusionsbarriere und bildet zugleich einen Haftvermittler für die Metallschicht.

Der Partialdruck des Sauerstoffs im Plasma der Magnetronkathoden mit Silbertargets kann durch Zugabe nur geringer Sauerstoffmengen gering gehalten werden, wenn zur Erzeugung der Grundschicht und der Deckschicht nahezu vollständig oxidierte ITO-Targets verwendet werden.

Das Verfahren liefert besonders gute Schichten, wenn das ITO-Target 85 bis 95 Gew.-%, vorzugsweise 90 Gew.-% In₂O₃ und 15 bis 5 Gew.-%, vorzugsweise 10 Gew.-% SnO₂ aufweist.

Die zu beschichtenden Substrate können mit gleichmäßiger Geschwindigkeit an den Magnetronkathoden vorbeigefahren, wenn gemäß einer anderen Ausgestaltung der Erfindung die unterschiedlichen Schichtdicken durch unterschiedliche Sputterraten der Magnetronkathoden und durch eine unterschiedliche Anzahl von Magnetronkathoden eines Materials erzeugt werden.

Die Wärmebehandlung der Substrate ist besonders schonend, wenn sie während der Beschichtung durch eine Heizung von der Rückseite der Substrate her erfolgt.

Die Erfindung läßt verschiedene Ausführungsformen zu. Zu ihrer weiteren Verdeutlichung wird nachfolgend auf die Zeichnung Bezug genommen. Diese zeigt in
- Fig.1: ein Diagramm, welches die optischen Werte einer Silberschicht auf Glas in Abhängigkeit von der Wellenlänge des Lichtes zeigt,
- Fig.2: ein der Figur 1 entsprechendes Diagramm für ein erfindungsgemäßes, beschichtetes Substrat und eine Schnittdarstellung des Substrates mit dem Schichtsystem,
- Fig.3: eine Prinzipskizze einer Sputteranlage zur Durchführung einer ersten Ausführungsform des erfindungsgemäßen Beschichtungsverfahrens,
- Fig.4: eine Prinzipskizze einer Sputteranlage zur Durchführung einer zweiten Ausführungsform des erfindungsgemäßen Beschichtungsverfahrens.

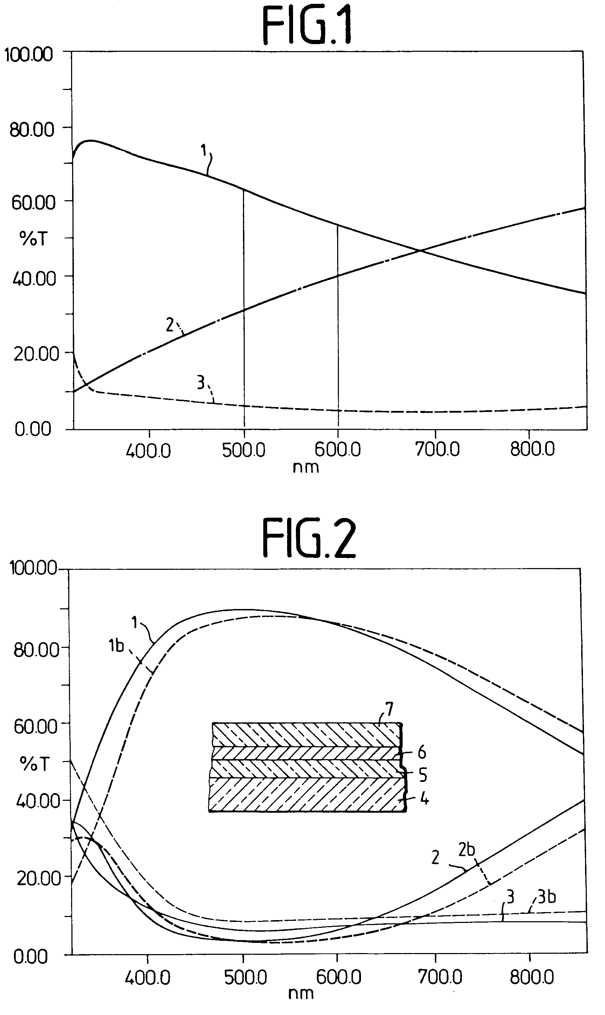

In dem Diagramm in Figur 1 sind die optischen Werte eines Substrates aus Glas mit einer Silberschicht von 10 nm gezeigt. Eine obere Linie 1 zeigt die Transmission, die tiefer verlaufende Linie 2 die Reflexion und die untere Linie 3 die Absorption. Zu erkennen ist, daß beispielsweise für eine Wellenlänge von 500 nm die Transmission infolge der hohen Reflexions- und Absorptionswerte kaum über 60 % liegt, so daß ein solches Substrat beispielsweise als Display wegen seiner zu geringen Durchsichtigkeit ungeeignet wäre.

Im Diagramm gemäß Figur 2 ist ein erfindungsgemäßes Substrat 4 dargestellt, welches aus Glas besteht. Auf dem Substrat 4 wurde nach einem Reinigungsvorgang durch Aufheizen, Glimmen oder Sputterätzen eine transparente 48,8 nm dicke Grundschicht 5 aus Indium-Zinn-Oxid (ITO-Schicht) aufgesputtert. Dieser Grundschicht 5 schließt sich eine Metallschicht 6 an, bei der es sich bei diesem bevorzugten Ausführungsbeispiel um eine Silberschicht von 10 nm Schichtdicke handelt. Auf eine Grundschicht kann verzichtet werden, wenn das Substratglas entsprechend vorbehandelt ist, eine Diffusion des Silbers in das Substrat oder bereits auf dem Substrat befindliche Kontaktschichten nicht möglich ist und auf eine optimale Transmission keinen großen Wert gelegt wird. Der Metallschicht 6 folgt eine Deckschicht 7 von 44 nm Schichtdicke, bei der es sich wiederum um eine Indium-Zinn-Oxid-Schicht handelt, welche durch teilreaktives Sputtern bei einem Partialdruck des Sauerstoffs von nicht über etwa 10⁻⁴ mb mit Magnetronkathoden und DC-Entladung von einem ITO-Target aufgebracht wurde. Wichtig ist bei diesem Verfahrensschritt, daß die Temperatur der Metallschicht 6 einen bestimmten Wert nicht übersteigt. Dieser Wert liegt für Silber bei etwa 150°C. Bei höheren Temperaturen käme es zu einer ungleichförmigen Ausbildung der Metallschicht 6.

In dem Diagramm nach Figur 2 läßt die oberste Linie 1 erkennen, daß für eine Wellenlänge des Lichtes von 500 nm die Transmission bei nahezu 90% liegt. Sie ist also wesentlich höher als bei einer Silberschicht ohne die erfindungsgemäße Deckschicht, welche eine entspiegelnde Wirkung ausübt. Unterhalb der Linie 1 ist eine Linie 1b dargestellt, welche die Transmission zeigt, die sich für das beschichtete Substrat nach einem etwa einstündigen Tempervorgang bei etwa 300°C ergibt.

Ein Tempervorgang des Schichtsystems bewirkt neben der Verbesserung der optischen Werte auch eine Herabsetzung des elektrischen Widerstandes. So konnte bei dem erfindungsgemäßen Schichtsystem der elektrische Flächenwiderstand von 6 Ohm/Square auf 3,2 Ohm/Square reduziert werden.

Eine Linie 2 zeigt wiederum die Reflexion und eine Linie 3 die Absorption. Mit 2b und 3b sind die entsprechenden, sich nach einem Tempervorgang ergebenden Linien gekennzeichnet. Man erkennt die durch das Tempern eintretende Verbesserung der optischen Werte und insbesondere im Vergleich zu Figur 1 die Verbesserung infolge der Deckschicht 7 und der Grundschicht 5.

Geht man von einer Metallschicht geringerer Dicke aus, beispielsweise einer Silberschicht von 8 nm, so erhält man mit dem gesamten Schichtsystem einen etwas höheren elektrischen Widerstand bei gleichzeitig etwas höherer optischen Transmission. Bei einer dagegen größeren Schichtdicke der Metallschicht von ca 12 nm erhält man einen geringeren elektrischen Widerstand bei einer etwas geringeren optischen Transmission. Innerhalb bestimmter Grenzen kann man deshalb durch die Wahl der Schichtdicke der Metallschicht den Widerstand auf Kosten der Transmission erniedrigen und umgekehrt die Transmission auf Kosten des Widerstandes erhöhen. Je nach Dicke der Metallschicht muß dabei auch die Dicke der Grundschicht und der Deckschicht angepaßt werden, um eine optimale Entspiegelung zu erzielen.

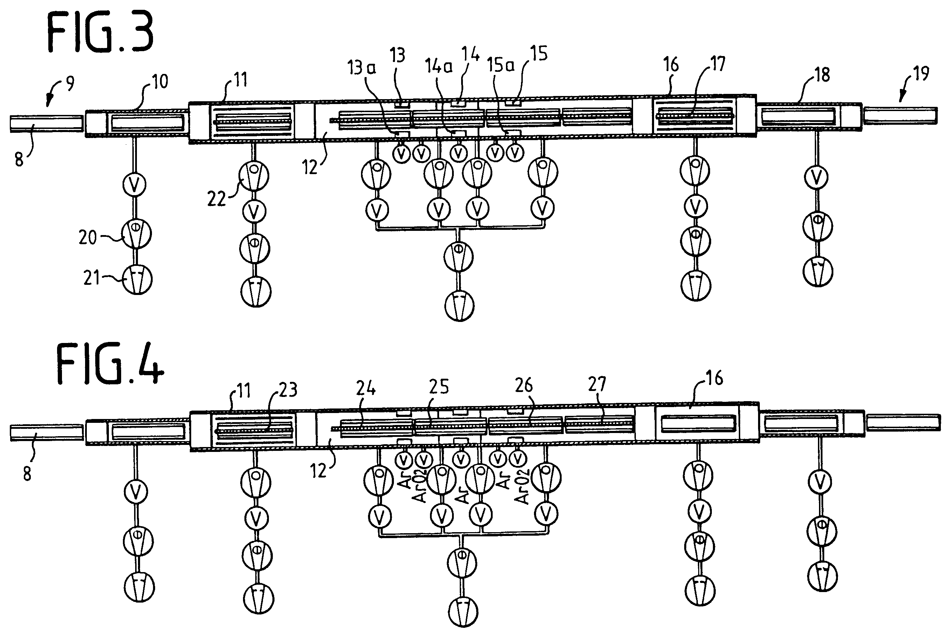

Zur weiteren Verdeutlichung des erfindungsgemäßen Verfahrens ist in Figur 3 eine vertikale Sputteranlage schematisch dargestellt, welche zur Aufbringung einer Beschichtung aus ITO, Silber und wiederum ITO auf einem Substrat bei geringen Substrattemperaturen und zur anschließenden Wärmebehandlung (Tempern) ausgebildet ist.

Durch eine solche Sputteranlage fährt ein Transportwagen 8 mit einem u-förmigen Profil, das es erlaubt, die in Figur 2 gezeigten Substrate 4 an den beiden Außenseiten zu befestigen. Nachdem das in einer Beladestation 9 erfolgt ist, wird der Transportwagen 8 in ein erstes Einschleusmodul 10 eingeschleust. Er gelangt anschließend in ein zweites Einschleusmodul 11, wo eine Reinigung der Substrate 4 entweder mittels einer Plasmaglimmentladung oder mittels kurzzeitigem Aufheizen über 100°C erfolgt. Danach werden die Transportwagen 8 in eine Sputterprozeßkammer 12 gefahren, wo sie durch Sputtern mit Magnetronkathoden 13, 14, 15 und 13a, 14a, 15a nacheinander mit ITO, Metall und nochmals ITO beschichtet werden. Damit diese Prozesse in einer Sputterprozeßkammer 12 simultan gefahren werden können, darf der Partialdruck des Sauerstoffs im Plasma der Magnetronkathoden 14 und 14a mit einem Silbertarget einen bestimmten Wert nicht überschreiten, da ansonsten die Schichteigenschaften der Silberschicht in Mitleidenschaft gezogen werden. Daher müssen zum Aufsputtern der ITO-Schichten nahezu vollständig oxidierte ITO-Targets verwendet werden, so daß keine oder nur eine sehr geringe Sauerstoffzugabe notwendig ist, um gute Schichteigenschaften zu erreichen.

Als ITO-Target kann ein Target mit 85 bis 95 Gew.-% In₂O₃ und 15 - 5 Gew.-% SnO₂ gewählt werden, bevorzugt wird eine Zusammensetzung von 90 Gew.-% In₂O₃ und 10 Gew.-% SnO₂.

Die Geschwindigkeit, mit der der Transportwagen 8 mit den Substraten 4 vor den Magnetronkathoden 13, 14, 15; 13a, 14a, 15a entlang fährt, ist vor allen Magnetronkathoden gleich. Deshalb werden die verschiedenen Schichtdicken über die verschiedenen Sputterraten der Magnetronkathoden 13, 14, 15; 13a, 14a, 15a eingestellt. Diese Sputterraten können unter anderem über die DC- oder HF-Leistungen der entsprechenden Sputterstromversorgungen eingestellt werden.

Nachdem das Schichtsystem auf die Substrate 4 aufgebracht wurde, fährt der Transportwagen 8 mit den Substraten aus der Sputterprozeßkammer 12 und fährt in ein erstes Ausschleusmodul 16, wo die Substrate 4 mittels einer Heizung 17 auf bis zu 300°C aufgeheizt werden. Die Heizung 17 greift in den u-förmigen Bereich des Transportwagens 8 ein und befindet sich dadurch zwischen den Substraten 4. Entsprechende Heizungen sind auch im zweiten Einschleusmodul 11 und in der Sputterprozeßkammer 12 vorgesehen.

Nach einer bestimmten Verweildauer im ersten Ausschleusmodul 16 fährt der Transportwagen 8 mit den beschichteten Substraten über ein zweites Ausschleusmodul 18 aus der Sputteranlage heraus und gelangt zu einer Entladestation 19. Dort werden die beschichteten Substrate dem Transportwagen 8 entnommen, der anschließend zur Beladestation 9 zurückfährt, um dort mit neuen Substraten beladen zu werden.

Die für die Evakuierung erforderlichen Pumpen sind in Figur 3 ebenfalls dargestellt. Während das erste Einschleusmodul 10 und das zweite Ausschleusmodul 18 nur beispielsweise mit einer Rootspumpe 20 und einer Trivacpumpe 21 als Vorpumpensystem versehen sind, sind beim zweiten Einschleusmodul 11, der Sputterprozeßkammer 12 und dem ersten Auschleusmodul 16 Hochvakuumpumpen 22, beispielsweise Turbomolekularpumpen, angeschlossen.

Die Sputteranlage nach Figur 4 unterscheidet sich von der nach Figur 3 dadurch, daß das erste Ausschleusmodul 16 keine Heizung aufweist. Im Unterschied zu der zuvor beschriebenen Sputteranlage werden die Substrate bereits im zweiten Einschleusmodul 11 mittels einer Heizung 23, die genau wie die Heizung 17 angeordnet ist, auf hohe Temperaturen von bis zu 300°C aufgeheizt. Während den Beschichtungen in der Sputterprozeßkammer 12 wird diese Temperatur mittel zentraler Heizelemente 24, 25, 26, 27 aufrechterhalten. Diese Heizelemente 24, 25, 26, 27 und auch die Heizung 23 ragen von oben her in eine u-förmige Ausbuchtung des Transportwagens 8 und heizen dadurch die Substrate von hinten. Ansonsten verläuft, abgesehen davon, daß die nachträgliche Wärmebehandlung entfällt, der Prozeß genau wie bei der Sputteranlage nach Figur 3.

In den Einschleusmodulen 11 nach den Figuren 3 und 4 und im ersten Ausschleusmodul 16 nach Figur 3 kann jeweils zusätzlich zu der mittig angeordneten Heizung 17, 23 an jeder Wand ein weiterer, nicht gezeigter Heizer installiert sein, um die Substrate schneller aufheizen zu können.

## Patentansprüche

1. Transparentes Substrat mit einem transparenten Schichtsystem, welches aus einer Metallschicht (6) und einer die Metallschicht (6) im sichtbaren Bereich entspiegelnden Deckschicht (7) besteht, wobei die Metallschicht (6) eine solche Schichtdicke hat, daß eine hohe Transparenz des Substrates (4) erhalten bleibt, **dadurch gekennzeichnet**, daß die Metallschicht (6) durch Beheizen des Substrates während der Beschichtung oder nach dem Erzeugen der Deckschicht (7) einer Wärmebehandlung unterzogen wurde.

2. Substrat nach Anspruch 1, **dadurch gekennzeichnet**, daß unterhalb der Metallschicht (6) eine Grundschicht (5) auf das Substrat (4) aufgetragen ist und diese Grundschicht (5) und die Deckschicht (7) aus Indium-Zinn-Oxid (ITO-Schicht) bestehen.

3. Substrat nach zumindest einem der vorangehenden Ansprüche, **dadurch gekennzeichnet**, daß die Metallschicht (6) aus Silber besteht und die Wärmebehandlung nach dem Erzeugen der Deckschicht erfolgte.

4. Substrat nach zumindest einem der vorangehenden Ansprüche, **dadurch gekennzeichnet**, daß die Metallschicht (6) aus Gold, Kupfer oder einer bei einer Wärmebehandlung nicht zum Reißen neigenden Legierung aus Silber, Gold oder Kupfer besteht und die Wärmebehandlung beim Erzeugen der Metallschicht und der ITO-Schichten durch Beheizen des Substrates erfolgte.

5. Substrat nach zumindest einem der vorangehenden Ansprüche, **dadurch gekennzeichnet**, daß die Metallschicht (6) eine Legierung aus Silber, Gold oder Kupfer und einem geringen Anteil eines Legierungsstoffes, wie Zirkonium, Vanadium, Nickel, Chrom, Molybdän, Platin, Paladium, Rhodium, Iridium, Silizium oder Wolfram ist.

6. Substrat nach zumindest einem der vorangehenden Ansprüche, **dadurch gekennzeichnet**, daß die Metallschicht (6) eine Legierung aus a) Silber und Kupfer, b) Silber und Gold oder c) Silber, Gold und Kupfer ist, wobei diesen Legierungen noch weitere geringe Anteile eines Legierungsstoffes wie Zirkonium, Vanadium, Nickel, Chrom, Platin, Palladium, Rhodium, Iridium, Silizium, Wolfram oder Molybdän zugesetzt sind.

7. Substrat nach Anspruch 6, **dadurch gekennzeichnet**, daß die Silberlegierung aus 71,9 Gew.-% Silber und 28,1 Gew.-% Kupfer besteht.

8. Substrat nach Anspruch 6, **dadurch gekennzeichnet**, daß die Silberlegierung 99,8 Gew.-% Silber und 0,15 Gew.-% Nickel enthält.

9. Substrat nach Anspruch 6, **dadurch gekennzeichnet**, daß die Silberlegierung aus 98,5 Gew.-% Silber und 1,5 Gew.-% Silizium besteht.

10. Substrat nach Anspruch 6, **dadurch gekennzeichnet**, daß die Legierung aus Silber, Gold und Kupfer 53,3 Gew.-% Silber, 33,3 Gew.-% Gold und 13,4 Gew.-% Kupfer enthält.

11. Substrat nach Anspruch 6, **dadurch gekennzeichnet**, daß die Legierung aus Silber, Gold und Kupfer 33,3 Gew.-% Gold, 33,4 Gew.-% Silber und 33,3 Gew.-% Kupfer enthält.

12. Substrat nach Anspruch 6, **dadurch gekennzeichnet**, daß die Legierung aus Silber, Gold und Kupfer 33,3 Gew.-% Gold, 53,3 Gew.-% Silber und 13,4 Gew.-% Kupfer enthält.

13. Substrat nach Anspruch 6, **dadurch gekennzeichnet**, daß die Legierung aus Silber, Gold und Kupfer 58,5 Gew.-% Gold, 13,8 Gew.-% Silber und 27,7 Gew.-% Kupfer enthält.

14. Substrat nach Anspruch 6, **dadurch gekennzeichnet**, daß die Legierung aus Silber, Gold und Kupfer 58,5 Gew.-% Gold, 20,8 Gew.-% Silber und 20,7 Gew.-% Kupfer enthält.

15. Substrat nach Anspruch 6, **dadurch gekennzeichnet**, daß die Legierung aus Silber, Gold und Kupfer 58,5 Gew.-% Gold, 24,9 Gew.-% Silber und 16,6 Gew.-% Kupfer enthält.

16. Substrat nach Anspruch 6, **dadurch gekennzeichnet**, daß die Legierung mindestens 50 Gew.-% Gold und als zusätzlichen Legierungsbestandteil Nickel, Palladium oder Silber aufweist.

17. Substrat nach zumindest einem der vorangehenden Ansprüche, **dadurch gekennzeichnet**, daß die Grundschicht (5) 40 bis 200 nm, die Deckschicht (7) 40 bis 60 nm und die Metallschicht (6) 8 bis 15 nm dick ist.

18. Substrat nach zumindest einem der vorangehenden Ansprüche, welches aus Glas besteht, **dadurch gekennzeichnet**, daß die Grundschicht (5) eine 48,8 nm dicke ITO Schicht, die Metallschicht (6) eine 10 nm dicke Silberschicht und die Deckschicht (7) eine 44 nm dicke ITO-Schicht ist.

19. Verfahren zur Herstellung eines transparenten, elektrisch leitfähigen Schichtsystems auf einem transparenten Substrat, bei dem auf dem Substrat zunächst eine Metallschicht mit einer solchen Schichtdicke aufgetragen wird, daß eine hohe Transparenz erhalten bleibt und bei dem anschließend eine transparente, die Metallschicht entspiegelnde Deckschicht aufgesputtert wird, **dadurch gekennzeichnet**, daß die Metallschicht (6) durch Beheizen des Substrates während der Beschichtung oder nach dem Erzeugen der Deckschicht (7) einer Wärmebehandlung bei Temperaturen bis zu 300°C unterzogen wird.

20. Verfahren nach Anspruch 8, **dadurch gekennzeichnet**, daß die Wärmebehandlung dadurch erfolgt, daß das Substrat nach der Beschichtung in einer Vakuumanlage oder einem Temperofen bei Temperaturen von bis zu 300°C bis zu einer Stunde getempert wird.

21. Verfahren nach den Ansprüchen 8 oder 9, **dadurch gekennzeichnet**, daß die Deckschicht durch teilreaktives Sputtern von einem ITO-Target hergestellt wird, wobei der Partialdruck des Sauerstoffs bei nicht über etwa 10⁻⁴ mb liegt.

22. Verfahren nach zumindest einem der Ansprüche 8 bis 10, **dadurch gekennzeichnet**, daß unmittelbar auf das Substrat vor dem Aufsputtern der Metallschicht eine Grundschicht aus Indium-Zinn-Oxid aufgesputtert wird.

23. Verfahren nach zumindest einem der vorangehenden Ansprüche, **dadurch gekennzeichnet**, daß zur Erzeugung der Grundschicht und der Deckschicht nahezu vollständig oxidierte ITO-Targets verwendet werden.

24. Verfahren nach zumindest einem der vorangehenden Ansprüche, **dadurch gekennzeichnet**, daß das ITO-Target 85 bis 95 Gew.-% In₂O₃ und 15 bis 5 Gew.-% SnO₂ aufweist.

25. Verfahren nach Anspruch 13, **dadurch gekennzeichnet**, daß das ITO-Target 90 Gew.-% In₂O₃ und 10 Gew.-% SnO₂ aufweist.

26. Verfahren nach zumindest einem der vorangehenden Ansprüche, **dadurch gekennzeichnet**, daß die unterschiedlichen Schichtdicken durch unterschiedliche Sputterraten der Magnetronkathoden erzeugt werden.

27. Verfahren nach zumindest einem der vorangehenden Ansprüche, **dadurch gekennzeichnet**, daß die unterschiedlichen Schichtdicken durch eine unterschiedliche Anzahl der Magnetronkathoden eines Materials erzeugt werden.

28. Verfahren nach zumindest einem der vorangehenden Ansprüche, **dadurch gekennzeichnet**, daß die Wärmebehandlung der Substrate während der Beschichtung durch eine Heizung von der Rückseite der Substrate her erfolgt.
